# FASCICULE DE BREVET EUROPEEN

(11) **EP 1 599 889 B1**
(45) Date de publication et mention de la délivrance du brevet: **03.01.2007**
(21) Numéro de dépôt: 03796049.9
(22) Date de dépôt: 24.11.2003
(51) Int. Cl.: H01H 13/70, H03M 11/24

(54) **DISPOSITIF D ENTREE DE DONNEES**
EINGABEVORRICHTUNG
DATA INPUT DEVICE

(30) Priorité: 25.11.2002 EP 02026166; 19.12.2002 LU 90995; 16.04.2003 LU 91020
(43) Date de publication de la demande: 30.11.2005
(73) Titulaire: IEE INTERNATIONAL ELECTRONICS & ENGINEERING S.A., 6468 Echternach (LU)
(72) Inventeur: SERBAN, Bogdan, 3376 Leudelange (LU); BOYER, Philippe, F-57570 Cattenom (FR)
(74) Mandataire: Beissel, Jean
(86) Numéro de dépôt international: PCT/EP2003/050887
(87) Numéro de publication internationale: WO 2004/049364

(56) Documents cités:
- EP-A- 0 134 853
- EP-A- 0 266 229
- EP-A- 0 489 344
- EP-A- 0 917 293
- LU-A- 88 024

## Description

### Introduction

La présente invention concerne un dispositif d'entrée de données et notamment un clavier, comme p.ex. un clavier numérique ou alpha-numérique.

Il est connu de construire des dispositifs d'entrée de données, tels que des claviers numériques ou alpha-numériques, à partir de commutateurs du type à feuille. Un commutateur du type à feuille comporte deux feuilles de support, qui sont arrangées à une certaine distance l'une de l'autre à l'aide d'un écarteur. L'écarteur comprend au moins un évidemment qui définit une zone active du commutateur dans laquelle les deux feuilles de support se font face. A l'intérieur de cette zone active, au moins deux électrodes sont arrangées de telle manière sur les deux feuilles de support, qu'un contact électrique est établi entre les électrodes lorsque les deux feuilles de support sont pressées ensemble sous l'effet d'une force agissant sur le commutateur.

Selon les applications, une couche en matière semi-conductrice peut être disposée entre les électrodes, de telle sorte que le commutateur montre un comportement sensible à la pression, c'est à dire que sa résistance varie en fonction de la force appliquée. Le caractère variable de la résistance électrique de tels commutateurs, qui sont connus sous le nom "Force Sensing Resistors", permet d'utiliser ces commutateurs comme des capteurs de pression. La couche en matière semi-conductrice peut comprendre soit une matière dont la résistance électrique interne varie en fonction d'une compression ou d'une déformation de la couche soit une matière dont la structuration de la surface confère à la couche une certaine résistance superficielle qui, lorsque la couche est appliquée contre une surface conductrice de l'électrode peut être réduite par suite d'une augmentation du nombre de points de contact avec cette surface conductrice sous l'effet d'une pression localisée.

Un dispositif d'entrée de données utilisant de tels commutateurs du type à feuilles est décrit dans le document EP-A-0 489 344. Ce dispositif comprend une pluralité de commutateurs arrangés sous forme de grille ou matrice aux endroits destinés à des touches du clavier. Afin de relier les différents commutateurs avec un circuit d'identification des touches, les commutateurs sont interconnectés en matrice, chaque commutateur étant connecté entre un connecteur de ligne et un connecteur de colonne respectivement. Un clavier comportant un nombre (*n*m*) de touches, c'est à dire (*n*m*) commutateurs, arrangées en n lignes et m colonnes nécessite ainsi au mois n conducteurs de ligne et m conducteurs de colonne afin de permettre d'interroger individuellement les *n*m* commutateurs (*n* et *m* représentent des nombres entiers quelconques). Par conséquent, ce dispositif nécessite *n*+*m* connexions avec l'extérieur afin de pouvoir relier le claver à une unité d'identification des touches.

Afin de réduire le nombre des connexions avec l'extérieur, des claviers comprenant une tablette digitalisante XYZ, c'est à dire un détecteur de position et d'intensité de la force, ont été présentés. Ces tablettes digitalisantes utilisent des capteurs de pression configurés comme potentiomètre linéaire afin de déterminer l'endroit d'action d'une force. A cette fin, chacun des capteurs de pression comprend une résistance linéaire disposée sur un support aux bornes de laquelle on applique une tension de manière à créer un gradient de potentiel. A intervalles réguliers, des lignes conductrices s'étendant latéralement sont reliées à ladite résistance linéaire. Le curseur du potentiomètre est formé par un conducteur en forme de peigne dont les dents s'étendent entre les lignes conductrices. En court-circuitant les lignes conductrices avec les dents du conducteur à un certain endroit, le conducteur est soumis à une tension qui varie linéairement avec la position de la ligne conductrice sur la résistance linéaire. Un tel capteur de pression permet donc de déterminer la position de l'action d'une force dans la direction de la résistance linéaire.

En superposant deux de ces capteurs de force de telle manière que leurs résistances linéaires respectives soient orientées dans un angle de p.ex. 90° entre-elles, on crée un détecteur de position, qui permet d'identifier la position d'action d'une force dans un repère X-Y sur une surface. Cette caractéristique peut évidemment être utilisée afin d'identifier une touche activée d'un clavier. Un tel clavier est p.ex. décrit dans le document LU-A-88 024. Dans un tel clavier, chacun des deux capteurs de force en forme de potentiomètre nécessite trois connexions, à savoir une connexion sur chacune des deux bornes de la résistance linéaire et une connexion pour le curseur. Il en résulte qu'un tel clavier permet de réduire le nombre des connexions avec l'extérieur par rapport à un clavier « en matrice » En effet, au lieu de nécessiter un nombre de (*n* x *m*) connexions (p.ex. 12 connections pour un clavier numérique avec 3 x 4 touches), ce type de clavier se contente de 6 connexions extérieures.

Un clavier comprenant plusieurs touches arrangées en au moins deux lignes est décrit dans le document EP-A-0 266 299. Le clavier comprend un premier conducteur constitué par une connexion en série de résistances étalonnées, un deuxième conducteur, les deux conducteurs pouvant être mis en contact au niveau de contacteurs. Dans le cas ou les touches du clavier sont disposées selon une configuration matricielle, par lignes et colonnes, les premier et deuxième conducteurs sont méandriformes.

Le document EP-A-0 134 853 décrit un moyen pour décoder une matrice de commutateurs. Le dispositif en question comprend deux conducteurs linéaires présentant chacun une pluralité de résistances ainsi que des conducteurs-traverses horizontaux et verticaux, connectées aux conducteurs linéaires entre les résistances. Aux endroits de croisement des conducteurs-traverses horizontaux avec les conducteurs-traverses verticaux se trouvent des commutateurs.

### Objet de l'invention

L'objet de la présente invention est de proposer un dispositif d'entrée de données qui réduit d'avantage le nombre des connexions extérieures.

### Description générale de l'invention

Conformément à l'invention, cet objectif est atteint par le dispositif d'entrée de données selon la revendication 1. Un tel dispositif d'entrée de données comprend plusieurs touches arrangées en au moins deux lignes. Un détecteur de position unidirectionnel est associé à chaque ligne de touches, chaque détecteur de position unidirectionnel comprenant une première connexion d'entrée, une deuxième connexion d'entrée et une connexion de sortie. Les connexions de sortie des détecteurs de position unidirectionnels sont reliées en différents endroits à une première résistance ohmique, et les premières connexions d'entrée sont reliées à une première borne du dispositif d'entrée de données et les deuxièmes connexions d'entrée sont reliées à une deuxième borne du dispositif d'entrée de données.

Un clavier numérique de quatre lignes à trois touches chacune (au total 12 touches) réalisé selon l'enseignement de la première revendication comprend donc quatre détecteurs de position unidirectionnels, dont un est associé à chaque ligne de touches. Ces détecteurs de position unidirectionnels permettent de détecter la position d'une force appliquée sur le clavier et ainsi d'identifier la touche de la ligne en question qui est activée. Ce détecteur de position unidirectionnel permet donc d'identifier une coordonnée X d'une force agissant sur le clavier.

Afin de déterminer la ligne de touches qui comprend la touche activée, c'est à dire afin de déterminer une coordonnée Y d'une force agissant sur le clavier, les différents détecteurs de position unidirectionnels sont branchés sur une première résistance ohmique dans un montage de diviseur de tension. En effet, en appliquant une différence de potentiel à la première résistance ohmique, les différents détecteurs de position sont soumis à des tensions différentes en raison de leur position de connexion sur la première résistance ohmique. En mesurant la tension à la première ou la deuxième borne du clavier, on sait par conséquent identifier le détecteur de position qui est activé et par conséquent la ligne comprenant la touche activée.

La présente invention propose donc un dispositif d'entrée de données tel qu'un clavier, qui nécessite seulement 4 connexions extérieures pour déterminer les coordonnées X-Y de l'action d'une force sur le clavier et donc pour identifier une touche activée. Ces 4 connexions sont notamment les première et deuxième bornes auxquelles sont reliées respectivement les premières et deuxièmes connexions des détecteurs de position unidirectionnels ainsi qu'une troisième et quatrième borne, entre lesquelles est branchée la première résistance ohmique.

L'interrogation d'un tel dispositif se fait en deux étapes :
□ Dans un premier temps, on applique une différence de potentiel entre les première et deuxième bornes du dispositif et on mesure la tension résultante aux bornes de la première résistance ohmique afin de déterminer la position X de la force sur le clavier. Après cette étape on connaît donc la colonne, dans laquelle la touche activée se situe.
□ Ensuite on applique une différence de potentiel entre les troisième et quatrième bornes du dispositif on mesure la tension résultante aux première et deuxième bornes afin de déterminer la position Y de la force sur le clavier. Ainsi on peut facilement identifier la ligne de touches, dans laquelle la touche activée se situe.

Contrairement aux claviers « en matrice », pour lequel un circuit d'évaluation doit balayer (scanner) en tout (*n* x *m*) touches afin de déterminer une activation éventuelle, le clavier de la présente invention ne nécessite que la détermination de tout au plus trois valeurs différentes afin d'évaluer une activation des touches. En effet, une interrogation du clavier se fait en déterminant une tension correspondant à une position X, une tension correspondant à une position Y et, selon l'exécution du clavier, éventuellement une tension correspondant à la force de l'activation de la touche activée. Il en résulte que la charge de travail d'un processeur du circuit d'évaluation est nettement réduit par rapport à celui d'un clavier « en matrice » et par conséquent que la consommation d'énergie est réduite. Ceci est notamment très important pour des applications de claviers dans des appareils portables tels que des téléphones mobiles ou sans fil.

Dans une exécution avantageuse de l'invention, ladite première résistance ohmique comprend une bande en matière résistive, lesdites connexions de sortie des détecteurs de position unidirectionnels étant reliées en différents endroits à ladite bande en matière résistive. La résistance ohmique peut p.ex. être imprimée en couche épaisse sur un substrat. Cette exécution est facile à réaliser et relativement peu coûteuse. La bande en matière résistive est de préférence disposée le long de la surface active du clavier afin de réduire la longueur des connections nécessaires pour relier les détecteurs de position à ladite première résistance. Cette exécution présente l'avantage de réduire également la complexité des tracés de ces conducteurs.

Dans une autre exécution possible, ladite première résistance ohmique comprend un montage en série d'une pluralité de résistances discrètes, lesdites connexions de sortie des détecteurs de position unidirectionnels étant reliées au montage en série en différents endroits entre des résistances discrètes. Les résistances discrètes peuvent comprendre des résisteurs discrets montés sur un substrat de circuit imprimé ou bien des simples couches de matière résistive imprimées en couche épaisse sur un substrat. Comme dans cette exécution, les détecteurs de position sont branchés en des endroits se situant entre les résistances discrètes, cette exécution permet de réduire les effets désavantageux des tolérances de production. Un autre avantage de cette exécution est du au fait, que les résistances discrètes peuvent être disposées dans un arrangement quelconque en un endroit du clavier, qui n'est pas soumis à des contraintes mécaniques. Cet avantage est surtout important dans le cas de claviers flexibles, ou les résistances peuvent être arrangées à un endroit qui n'est pas soumis à des déformations, p.ex. sur une patte de raccordement du clavier. Ainsi une dégradation des résistances due à la déformation peut être évitée.

Dans une exécution préférée de l'invention, un détecteur de position unidirectionnel comprend une pluralité de commutateurs discrets, lesdits commutateurs étant reliés d'un côté à la connexion de sortie du détecteur de position et de l'autre côté en différents endroits à une deuxième résistance ohmique, ladite deuxième résistance ohmique étant connectée entre les deux connexions d'entrée du détecteur de position. Les commutateurs discrets, p.ex. des interrupteurs à membrane ou des capteurs de pression, d'un tel détecteur de position sont connectés sous forme de diviseur de tension sur la deuxième résistance ohmique. En appliquant une différence de potentiel entre les bornes de la deuxième résistance ohmique, le signal mesuré à la connexion de sortie du détecteur est représentatif de la position du commutateur actionné.

Comme la première résistance ohmique, la deuxième résistance ohmique peut comprendre une bande en matière résistive, lesdits commutateurs étant reliés en différents endroits à ladite bande en matière résistive ou un montage en série d'une pluralité de résistances discrètes, lesdits commutateurs étant reliés au montage en série en différents endroits entre des résistances discrètes, ou une combinaison des deux. Le choix final entre ces exécutions est fait en fonction des avantages précités de ces exécutions.

Il est à noter que si le nombre de résistances de la deuxième résistance ohmique est égal pour plusieurs capteurs de position unidirectionnels et si les résistances ont des valeurs égales, les points de connexion des commutateurs d'une colonne de touches sont des points équipotentiels lors de l'application d'une différence de potentiel à travers les bornes. Il est dès lors possible, de brancher tous les commutateurs discrets faisant partie d'une colonne du clavier sur un même point de connexion d'une seule deuxième résistance ohmique.

Dans une autre exécution, un détecteur de position unidirectionnel comprend un capteur sous forme de diviseur de tension, ledit diviseur de tension comprenant une deuxième résistance ohmique s'étendant substantiellement le long de la ligne de touches du clavier, des lignes conductrices s'étendant à partir de la deuxième résistance ohmique et arrangées à une certaine distance l'une de l'autre, un conducteur en forme de peigne, dont les dents sont arrangées de manière interdigitale entre lesdites lignes conductrices, et une couche d'activation en matière semi-conductrice pour court-circuiter les lignes conductrices et les dents du conducteur à l'endroit d'action de la force. Dans une telle exécution le conducteur en forme de peigne est relié à la connexion de sortie du détecteur de position et la deuxième résistance ohmique est connectée entre les deux connexions d'entrée du détecteur de position. Ces capteurs sous forme de diviseur de tension sont bien connus dans l'état de la technique et présentent l'avantage de pouvoir librement définir des touches virtuelles en associant une certaine gamme de résistances à chacune des touches. Cette technique permet donc de définir selon les besoins plusieurs dispositions différentes de touches avec le même détecteur.

Dans une autre exécution, un détecteur de position unidirectionnel comprend plusieurs capteurs sous forme de diviseur de tension montés en série. Dans ce cas, la deuxième résistance ohmique se compose du montage en série des différentes résistances des capteurs individuels.

Pour les deux exécutions comprenant des capteurs sous forme de diviseurs de tension, les deuxièmes résistances sont habituellement des résistances linéaires, c'est à dire des résistances dont la conductivité est uniforme sur toute leur extension. Dans une exécution possible, la deuxième résistance ohmique du capteur sous forme de diviseur de tension peut par contre être une résistance non-linéaire, c'est à dire une résistance dont la conductivité est différente en différents endroits de la résistance. De cette manière il est possible de varier localement la résolution latérale d'un tel capteur, permettant ainsi de mieux détecter la position de l'activation sur la touche.

Il est à noter que la discrétisation des résistances resp. des commutateurs ou capteurs présente l'avantage, que les tensions mesurées dans une telle exécution doivent se situer dans des gammes bien définies et distinctes entre elles. Ceci est surtout très important lors de l'utilisation de capteurs de pression sous forme de commutateurs ou sous forme de diviseurs de tension, permettant non seulement de localiser l'action d'une force mais également de mesurer leur intensité. En discrétisant ainsi les gammes de tensions « valables », il devient possible de détecter une anomalie dans le fonctionnement du clavier notamment du à une charge initiale (preload) agissant sur le clavier et le cas échéant de compenser une telle précharge par un logiciel adapté.

Il sera apprécié que certaines des touches du davier peuvent avantageusement être rapprochées de manière à permettre un actionnement alternatif ou simultané de ces touches moyennant un seul élément de commande. Dans une exécution préférée d'un tel clavier deux touches de chaque direction (X et Y) du clavier sont rapprochées de manière à être disposées en groupe de quatre. Un actionnement des touches associées à l'une des directions peut être interprété par le circuit d'évaluation raccordé au clavier comme une commande de déplacement d'un curseur dans la direction en question. On peut ainsi réaliser une fonction « joystick » afin de faire défiler un écran ou bien de bouger un curseur sur un écran. L'élément de commande peut être un doigt de l'utilisateur qui peut balancer entre les touches rapprochées ou bien un levier disposé pardessus des touches actives qui sert de poignée de jeu.

Une telle fonction « joystick » se laisse facilement implémenter pour les deux directions principales X et Y du clavier. Pour la direction X, c'est à dire la direction dans laquelle s'étendent les détecteurs de positions unidirectionnels, au moins deux commutateurs discrets resp. deux capteurs sous forme de diviseur de tension d'un détecteur de positions unidirectionnel sont p.ex. disposées à une distance telle qu'un actionnement alternatif ou simultané des deux commutateurs discrets ou capteurs sous forme de diviseur de tension moyennant un élément de commande soit possible. Dans une exécution, dans laquelle chaque détecteur de position unidirectionnel comprend un capteur sous forme de diviseur de tension et dans laquelle des touches virtuelles sont définies pour un capteur sous forme de diviseur de tension en associant une certaine gamme de résistances à chacune des touches, au moins deux touches peuvent être définies de manière à être physiquement disposées à une distance telle qu'un actionnement alternatif ou simultané des deux touches moyennant un seul élément de commande soit possible.

Pour la direction Y du clavier, la fonction se laisse p.ex. réaliser si au moins deux détecteurs de position unidirectionnels sont disposées à une distance telle qu'un actionnement alternatif ou simultané des deux détecteurs de position moyennant un seul élément de commande soit possible.

Afin de permettre une affectation multiple de chaque touche du clavier moyennant une touche de fonction (shift, ctrl, alt), le clavier comprend de préférence au moins une troisième résistance ohmique branchée entre ladite première résistance ohmique et la borne respective du dispositif d'entrée de données ou entre ladite deuxième résistance ohmique et la borne respective du dispositif d'entrée de données, ladite troisième résistance ohmique étant court-circuitable à l'aide d'un circuit de dérivation muni d'un commutateur. En court-circuitant la troisième résistance, la résistance totale entre les bornes respectives est modifiée et par conséquent les valeurs de résistances resp. les tensions mesurées lors de l'activation d'une touche sont transposées dans une autre gamme de valeurs. Cette transposition des valeurs mesurées permet de différencier entre l'état « normal », dans lequel aucune touche de fonction n'est activée, et l'état « spécial », dans lequel une certaine touche de fonction est activée. L'homme du métier appréciera que selon le dimensionnement de la troisième résistance, la transposition des valeurs mesurée peut résulter en des valeurs qui se situent complètement en dehors de la gamme des valeurs normales ou bien en des valeurs qui sont intercalées entre les valeurs normales. Selon la résolution du système, il est même possible de réaliser plusieurs niveaux des valeurs intercalées.

Il est à noter que des troisièmes résistances peuvent avantageusement être prévues dans les deux directions du clavier permettant ainsi de réaliser quatre niveaux d'affectations de touches avec deux transpositions de valeurs dans chaque direction.

Dans une autre exécution, le clavier comprend au moins un montage en série d'une quatrième résistance ohmique et d'un commutateur, ledit montage en série étant branché en parallèle à ladite première résistance ohmique ou à ladite deuxième résistance ohmique. Cette exécution permet de détecter l'état actuel du clavier en mesurant le courant qui passe entre les bornes respectives du clavier. En effet, si la quatrième résistance est branchée, par l'actionnement du commutateur, en parallèle à la première resp. la deuxième résistance ohmique, le courant passant entre les bornes en question est plus élevé que si le commutateur est ouvert. En détectant une augmentation de ce courant, le circuit d'évaluation peut donc détecter un état spécial du clavier et interpréter dès lors les valeurs mesurées des tensions comme activation d'une fonction spéciale. Comme dans cette exécution, les valeurs des tensions mesurées aux bornes du clavier ne sont pas modifiées, elle n'est pas soumise à des limitations de résolution qui sont présentes dans le cas d'une transposition des valeurs. En branchant plusieurs résistances en parallèle à la première ou la deuxième résistance resp. en prévoyant plusieurs montages en série comprenant des quatrièmes résistances différentes, il est donc en principe possible de réaliser une multitude d'états différents du clavier.

Il est à noter que des quatrièmes résistances peuvent avantageusement être prévues dans les deux directions du clavier.

Il est clair que les différentes exécutions pour réaliser des états différents du clavier peuvent être combinées afin d'augmenter le nombre d'états possibles.

### Description à l'aide des figures

D'autres particularités et caractéristiques de l'invention ressortiront de la description détaillée de quelques modes de réalisation avantageux présentés ci-dessous, à titre d'illustration, en référence aux dessins annexés. Celles ci montrent:
- Fig.1:: Un schéma de montage d'une première exécution d'un dispositif d'entrée de données selon la présente invention ;
- Fig.2:: une première variante du dispositif de la fig.1 ;
- Fig.3:: une deuxième variante du dispositif de la fig.1 ;
- Fig.4:: une vue d'une exécution possible du dispositif de la fig. 1 ;
- Fig.5:: un schéma de montage d'une exécution d'un dispositif d'entrée de données comprenant des touches de fonction ;
- Fig.6:: une représentation graphique des valeurs de tension mesurées avec le dispositif de la fig. 5 ;
- Fig.7:: un schéma de montage d'une deuxième exécution d'un dispositif d'entrée de données comprenant des touches de fonction ;
- Fig.8:: une variante du dispositif de la fig. 7 ;
- Fig.9:: un schéma de montage d'une troisième exécution d'un dispositif d'entrée de données comprenant des touches de fonction ;
- Fig.10:: une variante du dispositif de la fig. 9 ;
- Fig.11:: un schéma de montage d'une exécution d'un dispositif d'entrée de données selon la présente invention comprenant des commutateurs discrets ;
- Fig.12:: un schéma de montage d'une variante de l'exécution de la fig. 11.

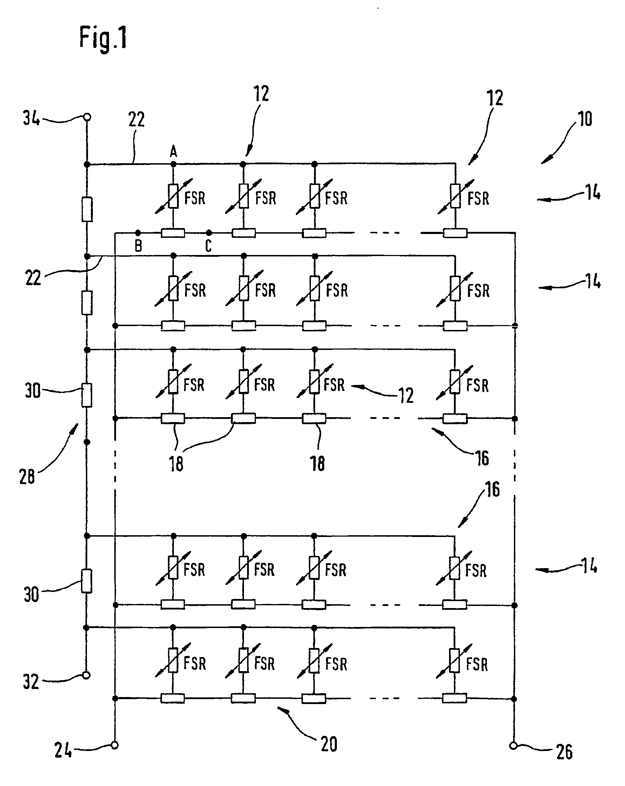

La fig. 1 représente un schéma de montage d'une exécution d'un clavier 10 comprenant une pluralité de touches 12 schématiquement représentées par des résistances variables (FSR). Les touches du clavier sont représentées dans un arrangement en grille avec plusieurs lignes 14 de touches.

A chaque ligne 14 de touches est associé un détecteur de position unidirectionnel 16. Un tel détecteur de position 16 peut p.ex. comprendre plusieurs capteurs sous forme de diviseur de tension. Un tel capteur diviseur de tension comprend une résistance ohmique 18 s'étendant substantiellement le long d'une surface active du capteur, des lignes conductrices s'étendant à partir de la résistance ohmique et arrangées à une certaine distance l'une de l'autre, un conducteur en forme de peigne, dont les dents sont arrangées de manière interdigitale entre lesdites lignes conductrices, et une couche d'activation en matière semi-conductrice pour court-circuiter les lignes conductrices et les dents du conducteur à l'endroit d'action de la force. Comme ces capteurs sont bien connus dans l'état de la technique, les détails des capteurs ne sont pas représentés sur la fig. 1. Dans les figures, les capteurs sont schématiquement représentés par une résistance variable (FSR) branché d'un côté sur une résistance 18. Les capteurs diviseurs de tension sont branchés en série de telle manière que le montage en série des résistances 18 constitue la deuxième résistance ohmique 20 du dispositif de la présente invention. Les conducteurs en forme de peigne des diviseurs de tension sont reliés ensemble pour former une connexion de sortie 22 du détecteur de position.

Les extrémités respectives des résistances ohmiques 20 de chaque détecteur de position unidirectionnel sont reliées entre elles pour former une première borne 24 et une deuxième borne 26 du clavier. Les connexions de sortie des détecteurs de position sont à leur tour reliées en différents endroits à une première résistance ohmique 28, formée dans l'exemple de la fig. 1 par un montage de différentes résistances individuelles 30. Dans cette exécution, les connexions de sortie 22 des détecteurs de position unidirectionnels sont reliées au montage en série en différents endroits entre des résistances discrètes 30. les deux extrémités de la résistance ohmique 28, resp. du montage en série des résistances 30 forment la troisième borne 32 et la quatrième borne 34 du clavier.

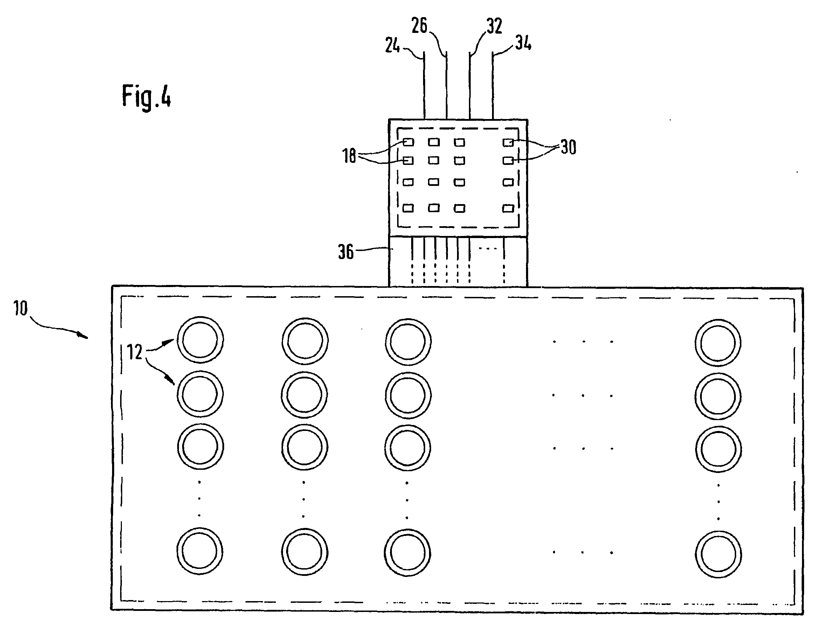

Il convient à noter que la fig. 1 montre un schéma de montage d'un clavier, c'est à dire que la figure ne représente pas nécessairement la disposition physique des différentes composantes du clavier. Dans une réalisation physique d'un clavier selon la fig. 1, les résistances 30 ne doivent pas être disposées physiquement à proximité de la surface active du clavier. En effet il est avantageux, notamment dans le cas de claviers flexibles, de disposer les résistances à un endroit du clavier, qui n'est pas soumis à des déformations. Une telle exécution d'un clavier est représentée à la fig. 4. Dans cette exécution, les résistances 30 sont disposées sur une patte de raccordement 36 du clavier. Cette patte de raccordement peut être renforcée afin de limiter les déformations de celle-ci. Ainsi une dégradation des résistances 30 due à la déformation peut être évitée.

Il est à noter qu'au lieu d'une pluralité de capteurs diviseurs de tension, le détecteur de position pourrait aussi bien comprendre un seul capteur diviseur de tension qui s'étend sur toute la largeur de la ligne de touches. Dans ce dernier cas, les différentes touches sont virtuellement délimitées en associant à chaque touche une gamme bien définie de résistances sur la deuxième rési stance ohmique.

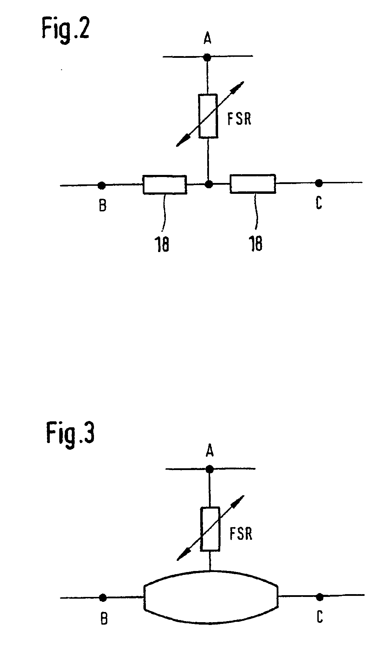

Dans une autre exécution possible du détecteur de position, celui-ci comprend une pluralité de commutateurs branchés avec l'un de leurs contacts sous forme de diviseur de tension soit sur une résistance ohmique soit sur un montage en série de résistances 18. Les autres contacts des commutateurs sont reliés ensemble pour former une connexion de sortie 22 du détecteur de position. Les commutateurs du capteur de position peuvent être des simples interrupteurs à membranes ou dans une exécution avantageuse, des capteurs de pression p.ex. du type « Force Sensing Resistor » décrit plus haut. Une telle exécution avec des capteurs FSR est schématiquement montrée dans la fig. 2. Il est à noter qu'avec cette exécution, les résistances 18 ne doivent pas être disposées à proximité des touches du clavier mais peuvent, tout comme les résistances 30, être disposées dans la patte de raccordement 36 du clavier (fig. 4).

La fig. 3 montre une autre variante des capteurs de position. Dans cette variante, les détecteurs de position comprennent des capteurs sous forme de diviseurs de tension, dans lesquels la résistance 18 est une résistance non-linéaire, c'est à dire une résistance dont la conductivité est différente en différents endroits de la résistance. Dans le cas représenté, la conductivité est plus élevée au centre du capteur qu'aux bords. De cette manière il est possible de varier localement la résolution latérale d'un tel capteur, permettant ainsi de mieux détecter la position de l'activation sur la touche.

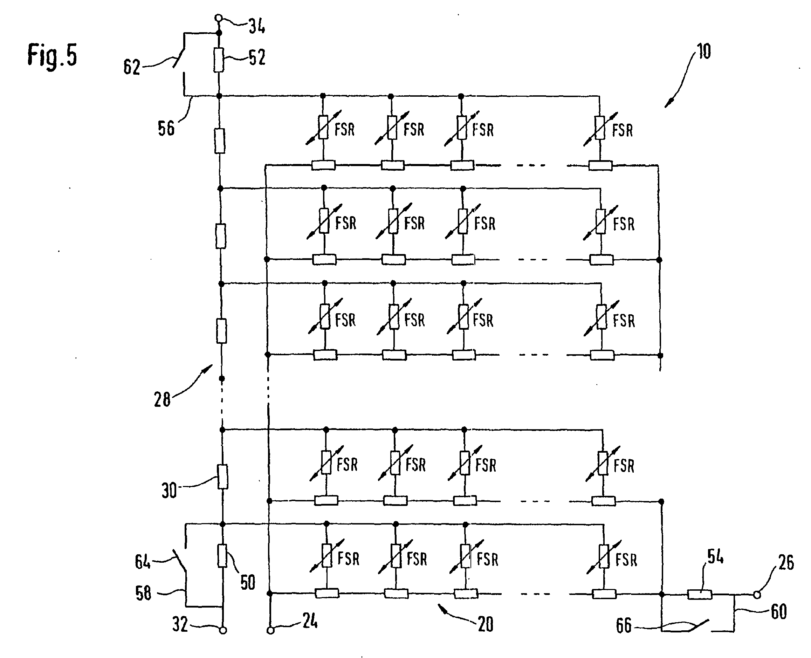

La fig. 5 montre un schéma de montage d'une exécution d'un dispositif d'entrée de données comprenant des touches de fonction. Afin de permettre une affectation multiple de chaque touche du clavier moyennant une touche de fonction (shift, ctrl, alt), ce clavier comprend des résistances supplémentaires 50, et 52 qui sont branchées aux extrémités de la résistance ohmique 28 entre celle-ci et les bornes 32 et 34 respectivement. De même, une résistance supplémentaire 54 est branchée entre les extrémités des deuxièmes résistances ohmiques 20 et la borne 26. Chacune des résistances 50, 52, 54 est court-circuitable à l'aide d'un circuit de dérivation 56, 58, 60 muni d'un commutateur 62, 64, 66. En court-circuitant l'une des résistances 50, 52, 54, la résistance totale entre les bornes respectives est modifiée et par conséquent les valeurs de résistances resp. les tensions mesurées lors de l'activation d'une touche sont transposées dans une autre gamme de valeurs. Cette transposition des valeurs mesurées permet de différencier entre l'état « normal », dans lequel aucune touche de fonction n'est activée, et l'état « spécial », dans lequel une certaine touche de fonction est activée. L'homme du métier appréciera que selon le dimensionnement des résistances, la transposition des valeurs mesurée peut résulter en des valeurs qui se situent complètement en dehors de la gamme des valeurs normales ou bien en des valeurs qui sont intercalées entre les valeurs normales. Selon la résolution du système, il est même possible de réaliser plusieurs niveaux des valeurs intercalées.

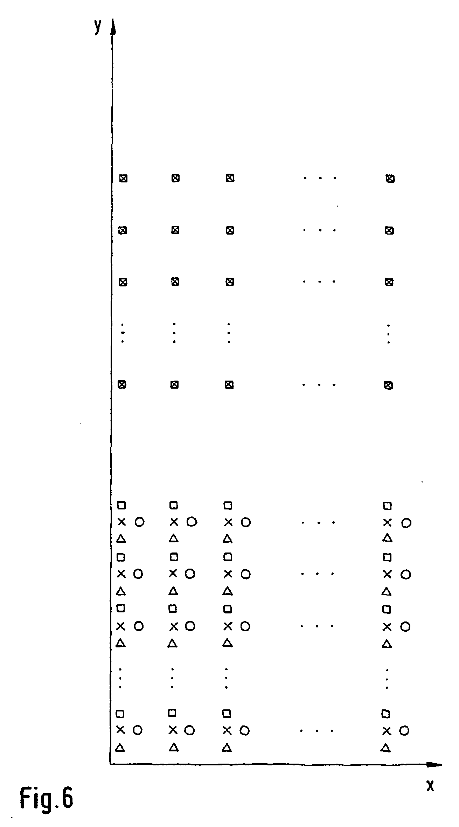

La fig. 6 montre une représentation graphique des valeurs de tension mesurées avec le dispositif de la fig. 5. Dans le graphe, les points marqués par une croix représentent des valeurs de tension mesurées lors de l'activation des touches du clavier lorsque aucun des commutateurs 62, 64, 66 n'est actionné. Lorsque le commutateur 64 est actionné, les tensions appliquées aux différentes résistances sont abaissées et les tensions mesurées pour la localisation d'une touche dans la direction Y sont abaissées par rapport aux valeurs normales. Ces valeurs abaissées sont représentées par les triangles.

En revanche, si le commutateur 64 est actionné, les tensions appliquées aux différentes résistances sont augmentées et les tensions mesurées pour la localisation d'une touche dans la direction Y sont augmentées par rapport aux valeurs normales. Deux cas peuvent alors se présenter :
- si la valeur de la résistance 52 est inférieure à celle des résistances 30, l'augmentation des tensions appliquées aux résistances 30 est inférieure à la différence de tension entre deux résistances 30 consécutives. Dans ce cas, les tensions mesurées lors de la localisation d'une touche dans la direction Y ne sont que légèrement augmentées par rapport aux valeurs normales et s'intercalent entre ces valeurs normales. Ces valeurs augmentées sont représentées par les carrés.
- Si par contre la résistance 52 est considérablement supérieure à la somme des résistances 30, la différence de potentiel appliquée à travers le montage en série des résistances 30 change radicalement. Dans ce cas, les valeurs mesurées peuvent être transposées dans une plage du graphique, qui se situe complètement en dehors de la gamme des valeurs normales. Ce cas est représenté par les carrés barrés dans la partie supérieure du graphique.

Les valeurs transposées lors de l'activation du commutateur 66 sont représentées dans la fig. 6 par de cercles. Ces valeurs sont augmentées par rapport aux valeurs normales en raison de l'augmentation de la différence de potentiel appliqué aux résistances ohmiques 20 à la suite au court-circuit de la résistance 54. Il est à noter qu'une autre résistance supplémentaire pourrait être prévue entre l'autre extrémité des résistances ohmiques 20 et la borne 24.

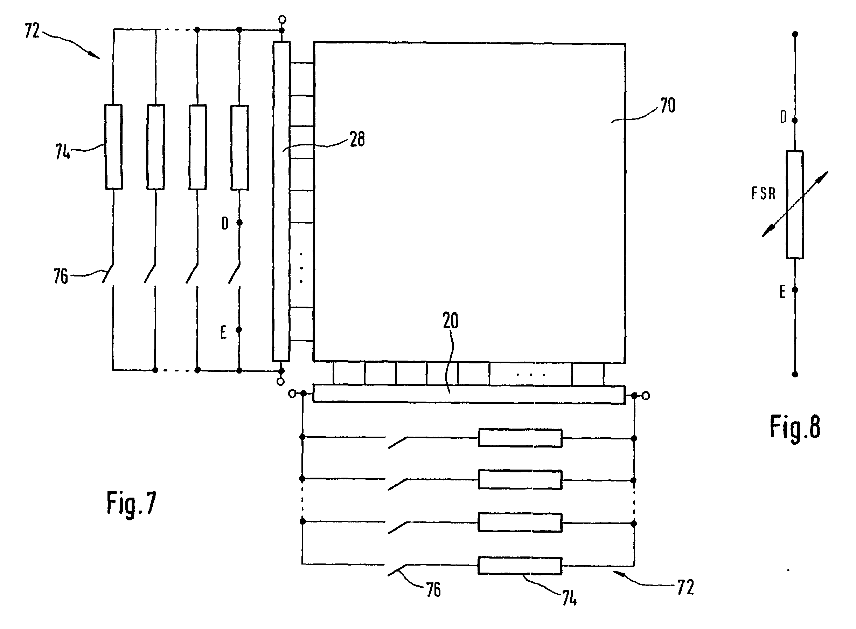

Les figures 7 à 10 montrent plusieurs exécutions d'un autre clavier avec touches de fonction. Dans ces figures la zone d'activation du clavier est schématiquement représenté en 70 et les résistances ohmiques 28 et 20 sont représentées en tant que bandes résistives.

Dans l'exécution de la fig. 7 et fig. 8, le davier comprend plusieurs montages en série 72 d'une résistance ohmique 74 et d'un commutateur 76, qui sont branchés en parallèle à la première résistance ohmique 28 respectivement à la deuxième résistance ohmique 20. Cette exécution permet de détecter l'état actuel du clavier en mesurant le courant qui passe entre les bornes respectives du clavier. En effet, si l'une des résistances 74 est branchée, par l'actionnement du commutateur 76 associé, en parallèle à la première resp. la deuxième résistance ohmique 28 resp. 20, le courant passant entre les bornes en question est plus élevé que si le commutateur 76 est ouvert. En détectant une augmentation de ce courant, le circuit d'évaluation peut donc détecter un état spécial du clavier et interpréter dès lors les valeurs mesurées des tensions comme activation d'une fonction spéciale.

Il est à noter que les valeurs de résistance des différentes résistances pour chaque direction sont de préférence différentes les unes de l'autre afin de pouvoir distinguer le commutateur qui a été actionné. Dans une autre exécution possible, toutes les résistances peuvent être égales et la distinction des différents états du clavier se fait par le nombre de commutateurs 76 actionnés simultanément. Il reste à noter que les commutateurs peuvent comprendre de simples interrupteurs à membranes ou de capteurs de force du type FSR comme représenté à la fig. 8.

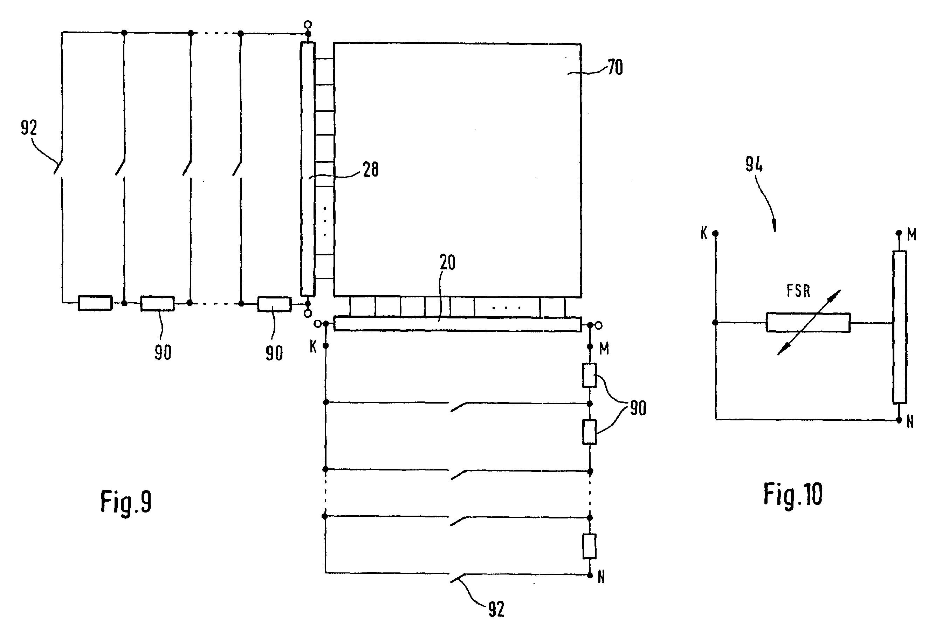

Une autre version d'un clavier est représentée aux figures 9 et 10. Dans cette exécution, une résistance ohmique ou un montage en série de résistances discrètes 90 peut être branché en parallèle à la résistance 28 et à la résistance 20 au moyen de commutateurs 92. Des lignes conductrices comprenant un commutateur sont prévues entre les différentes résistances 90 et une borne commune K, de manière à pouvoir court-circuiter une partie du montage en série des résistances 90. De cette manière on peut facilement réaliser un montage en parallèle de la résistance 28 resp. 20 avec une « résistance ohmique » variable.

Dans une réalisation avantageuse d'une telle exécution, un potentiomètre linéaire FSR 94 est branché en parallèle aux résistances 28 resp. 20. Une telle exécution est schématiquement représenté dans la fig. 10. Cette variante permet de continuellement varier la résistance parallèle applicable entre les bornes 24 et 26 en fonction de l'endroit d'activation du potentiomètre 94 et ainsi de définir une multitude de touches de fonctions virtuelles et par conséquent d'états spéciaux.

L'homme du métier appréciera que les mesures techniques décrites ci-dessus afin d'implémenter des touches de fonction pourront s'appliquer à tout clavier résistif, c'est à dire fonctionnant selon un principe de mesure de résistances afin d'identifier une touche activée, comme p.ex. les claviers à tablettes digitalisant YX ou YXZ. De plus, toutes ces mesures peuvent être implémentées sans nécessité d'augmenter le nombre de contacts avec l'extérieur. En effet il sera apprécié que dans les dispositifs décrits ci-dessus à l'aide des figures 5 à 10, le nombre de bornes pour un raccordement du clavier reste inchangé par rapport à celui du dispositif décrit en référence aux figures 1 à 4.

Il reste à noter que toutes les exécutions possibles décrites ci-dessus sont de préférence réalisées en tant que clavier membrane. Dans une telle réalisation, les résistances ohmiques 18, 30, 50, 52, 54, 74, 90, les lignes conductrices, les conducteurs en forme de peigne et les couches en matière semi-conductrice des capteurs diviseurs de tension, les contacts des commutateurs 60, 62, 64, 72, 92 et les conducteurs reliant les différents éléments sont de préférence déposés (p.ex. imprimés) sur des substrats flexibles (films en matière plastique isolants, textiles etc.), qui sont ensuite laminés ensemble. Cette technique permet de produire des claviers de haute qualité à des coûts raisonnables.

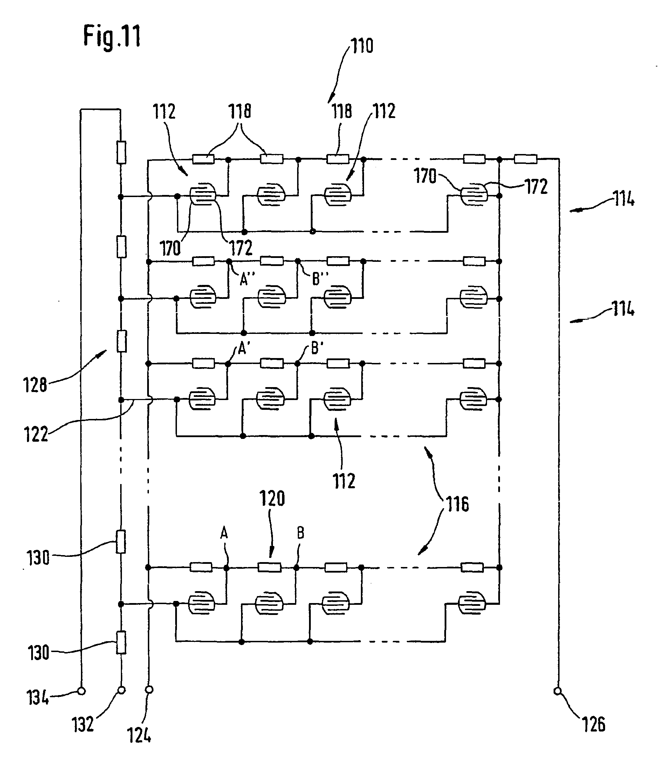

La fig. 11 représente un schéma de montage d'une exécution d'un clavier 110 comprenant une pluralité de touches configurés comme des commutateurs discrets 112. Tout comme pour le clavier 10 de la fig. 1, les touches 112 du clavier 100 sont arrangées en grille avec plusieurs lignes 114 de touches. A chaque ligne 114 de touches est associé un détecteur de position unidirectionnel 116 comprenant plusieurs commutateurs discrets 112.

Chaque commutateur discret comprend deux structures d'électrodes en forme de peigne 170 et 172 qui sont disposées de manière à ce que les doigts d'une des structures en forme de peigne s'intercalent à une certaine distance avec les doigts de l'autre structure. Une couche d'activation, qui peut être une simple couche conductrice ou bien une couche sensible à la pression, est arrangée sur un deuxième substrat (non représenté) de telle manière que les deux structures 170 et 172 d'un commutateur discret sont court-circuitées par la couche d'activation lorsqu'une force agit sur le dispositif dans la région du commutateur discret.

Chacun des commutateurs discrets est relié d'un côté à la connexion de sortie 122 du détecteur de position 116 et de l'autre côté en différents endroits à une deuxième résistance ohmique 120 constituée par une chaîne de résistances discrètes 118, qui elle est connectée entre les deux connexions d'entrée du détecteur de position qui forment les bornes 124 et 126 du clavier.

Les commutateurs discrets 112, p.ex. des interrupteurs à membrane ou des capteurs de pression, d'un tel détecteur de position sont donc connectés sous forme de diviseur de tension sur la deuxième résistance ohmique 120. En appliquant une différence de potentiel entre les bornes de la deuxième rési stance ohmique 120, le signal mesuré à la connexion de sortie du détecteur est représentatif de la position du commutateur actionné.

Les connexions de sortie 122 des détecteurs de position 116 sont à leur tour reliées en différents endroits à une première résistance ohmique 128, formée dans l'exemple de la fig. 11 par un montage de différentes résistances individuelles 130. Dans cette exécution, les connexions de sortie 122 des détecteurs de position unidirectionnels sont reliées au montage en série en différents endroits entre des résistances discrètes 130. Les deux extrémités de la résistance ohmique 128, resp. du montage en série des résistances 130, forment la troisième borne 132 et la quatrième borne 134 du clavier.

Si le nombre de résistances 118 est égal pour tous les capteurs de position unidirectionnels 116 et si les résistances 118 ont des valeurs égales, les points de connexion A, A', A" etc. sont des points équipotentiels lors de l'application d'une différence de potentiel à travers les bornes 124 et 126. Il en est de même pour les points de connexion B, B', B" etc.

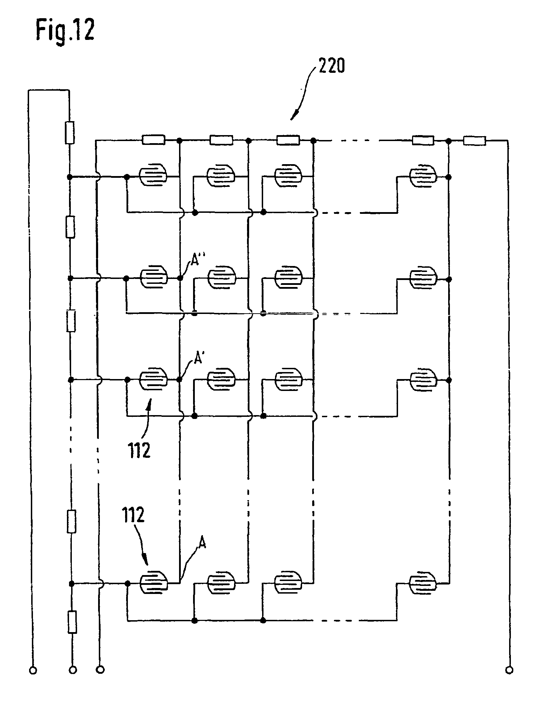

Il est dès lors possible, de brancher tous les commutateurs discrets 112 faisant partie d'une colonne du clavier sur un même point de connexion d'une seule deuxième résistance ohmique 220. Une telle variante du clavier est représenté sur la fig. 12.

### Liste des signes de référence

- 10,110: clavier
- 12,112: touche
- 14,114: lignes de touches
- 16,116: détecteur de position
- 18,118: résistance ohmique
- 20,120: résistance ohmique
- 22,122: connexion de sortie du détecteur de position
- 24,124: première borne
- 26,126: deuxième borne
- 28,128: première résistance ohmique
- 30,130: résistances individuelles
- 32,132: troisième borne
- 34,134: quatrième borne
- 36: patte de raccordement
- 50, 52, 54: résistances supplémentaires
- 56, 58, 60: un circuits de dérivation
- 62, 64, 66: commutateurs
- 70: zone d'activation du clavier
- 72: montage en série
- 74: résistance ohmique
- 76: commutateur
- 90: résistances discrètes
- 92: commutateur
- 94: potentiomètre linéaire FSR

## Revendications

1. Dispositif d'entrée de données (10, 110) comprenant plusieurs touches (12, 112), lesdites touches étant arrangées en au moins deux lignes (14, 114), **caractérisé**
**en ce que** le dispositif d'entrée de données (10, 110) comprend une pluralité de détecteurs de position unidirectionnels (16, 116), un détecteur de position unidirectionnel (16, 116) étant associé à chaque ligne de touches (14, 114), chaque détecteur de position unidirectionnel (16, 116) comprenant une première connexion d'entrée, une deuxième connexion d'entrée et une connexion de sortie (22, 122),
**en ce que** les connexions de sortie (22, 122) des détecteurs de position unidirectionnels (16, 116) sont reliées en différents endroits à une première résistance ohmique (28, 128), et
**en ce que** les premières connexions d'entrée sont reliées à une première borne (24, 124) du dispositif d'entrée de données et les deuxièmes connexions d'entrée sont reliées à une deuxième borne (26, 126) du dispositif d'entrée de données (10, 110).

2. Dispositif selon la revendication 1, dans lequel ladite première résistance ohmique (28) comprend une bande en matière résistive, lesdites connexions de sortie (22, 122) des détecteurs de position unidirectionnels (16, 116) étant reliées en différents endroits à ladite bande en matière résistive.

3. Dispositif selon la revendication 1, dans lequel ladite première résistance ohmique (28, 128) comprend un montage en série d'une pluralité de résistances discrètes (30, 130), lesdites connexions de sortie (22, 122) des détecteurs de position unidirectionnels (16, 116) étant reliées au montage en série en différents endroits entre des résistances discrètes (30, 130).

4. Dispositif selon l'une des revendications 1 à 3, dans lequel un détecteur de position unidirectionnel (16, 116) comprend une pluralité de commutateurs discrets, lesdits commutateurs étant reliés d'un côté à la connexion de sortie (22, 122) du détecteur de position (16, 116) et de l'autre côté en différents endroits à une deuxième résistance ohmique (20, 120), ladite deuxième résistance ohmique (20, 120) étant connectée entre les deux connexions d'entrée du détecteur de position.

5. Dispositif selon la revendication 4, **caractérisé en ce que** ladite deuxième résistance ohmique (20, 120) comprend une bande en matière résistive, lesdits commutateurs étant reliés en différents endroits à ladite bande en matière résistive.

6. Dispositif selon la revendication 4, dans lequel ladite deuxième résistance ohmique (20, 120) comprend un montage en série d'une pluralité de résistances discrètes (18, 118), lesdits commutateurs étant reliés au montage en série en différents endroits entre des résistances discrètes (18, 118).

7. Dispositif selon l'une des revendications 1 à 3, dans lequel un détecteur de position unidirectionnel (16, 116) comprend un capteur sous forme de diviseur de tension, ledit diviseur de tension comprenant une deuxième résistance ohmique (20, 120) s'étendant substantiellement le long de la ligne de touches du clavier, des lignes conductrices s'étendant à partir de la deuxième résistance ohmique (20, 120) et arrangées à une certaine distance l'une de l'autre, un conducteur en forme de peigne, dont les dents sont arrangées de manière interdigitale entre lesdites lignes conductrices, et une couche d'activation en matière semi-conductrice, dans lequel le conducteur en forme de peigne est relié à la connexion de sortie (22, 122) du détecteur de position (16, 116) et la deuxième résistance ohmique (20, 120) est connectée entre les deux connexions d'entrée du détecteur de position (16, 116).

8. Dispositif selon l'une des revendications 1 à 3, dans lequel un détecteur de position unidirectionnel (16, 116) comprend plusieurs capteurs sous forme de diviseur de tension montés en série.

9. Dispositif selon l'une des revendications 7 ou 8, dans lequel la deuxième résistance ohmique du capteur sous forme de diviseur de tension est une résistance non-linéaire.

10. Dispositif selon l'une des revendications 1 à 9, comprenant au moins une troisième résistance ohmique (50, 52, 54) branchée entre ladite première résistance ohmique (28) et la borne respective (32, 34) du dispositif d'entrée de données (10) ou entre ladite deuxième résistance ohmique (20) et la borne respective (26) du dispositif d'entrée de données (10), ladite troisième résistance ohmique (50, 52, 54) étant court-circuitable à l'aide d'un circuit de dérivation (56, 58, 60) muni d'un commutateur (62, 64, 66).

11. Dispositif selon l'une des revendications 1 à 10, comprenant au moins un montage en série (72) d'une quatrième résistance ohmique (74) et d'un commutateur (76), ledit montage en série (72) étant branché en parallèle à ladite première résistance ohmique (28) ou à ladite deuxième résistance ohmique (20).

12. Dispositif selon l'une des revendications 4 à 6, dans lequel au moins deux commutateurs discrets (112) sont disposées à une distance telle qu'un actionnement alternatif ou simultané des deux commutateurs discrets (112) moyennant un seul élément de commande soit possible.

13. Dispositif selon la revendication 8, dans lequel au moins deux capteurs sous forme de diviseur de tension sont disposées à une distance telle qu'un actionnement alternatif ou simultané des deux capteurs sous forme de diviseur de tension moyennant un seul élément de commande soit possible.

14. Dispositif selon la revendication 7 ou 8, dans lequel des touches virtuelles sont définies pour un capteur sous forme de diviseur de tension en associant une certaine gamme de résistances à chacune des touches, et dans lequel au moins deux touches sont définies de manière à être physiquement disposées à une distance telle qu'un actionnement alternatif ou simultané des deux touches moyennant un seul élément de commande soit possible.

15. Dispositif selon l'une des revendications précédentes, dans lequel au moins deux détecteurs de position unidirectionnels (16, 116) sont disposées à une distance telle qu'un actionnement alternatif ou simultané des deux détecteurs de position (16, 116) moyennant un seul élément de commande soit possible.

16. Dispositif selon l'une des revendications 4 à 6, dans lequel lesdits commutateurs discrets de plusieurs détecteurs de position unidirectionnels sont reliés à une même deuxième résistance ohmique.

## Claims

1. A data input device (10,110) comprising several keys (12, 112), said keys being arranged in at least two rows (14, 114), **characterized**
**in that** the data input device (10, 110) comprises a plurality of unidirectional position detectors (16,116), a unidirectional position detector (16,116) being associated with each row of keys (14,114), each unidirectional position detector (16, 116) comprising a first input connection, a second input connection and an output connection (22, 122),
**in that** the output connections (22, 122) of the unidirectional position detectors (16, 116) are connected at various locations to a first ohmic resistor (28, 128), and
**in that** the first input connections are connected to a first terminal (24, 124) of the data input device and the second input connections are connected to a second terminal (26, 126) of the data input device (10, 110).

2. The device as claimed in claim 1, in which said first ohmic resistor (28) comprises a strip of resistive material, said output connections (22, 122) of the unidirectional position detectors (16, 116) being connected at various locations to said strip of resistive material.

3. The device as claimed in claim 1, in which said first ohmic resistor (28, 128) comprises a series layout of a plurality of discrete resistors (30, 130), said output connections (22, 122) of the unidirectional position detectors (16, 116) being connected to the series layout at various locations between discrete resistors (30, 130)

4. The device as claimed in any one of claims 1 to 3, in which a unidirectional position detector (16, 116) comprises a plurality of discrete switches, said switches being connected on one side to the output connection (22, 122) of the position detector (16, 116) and on the other side at various locations to a second ohmic resistor (20, 120), said second ohmic resistor (20, 120) being connected between the two input connections of the position detector

5. The device as claimed in claim 4, **characterized in that** said second ohmic resistor (20, 120) comprises a strip of resistive material, said switches being connected at various locations to said strip of resistive material.

6. The device as claimed in claim 4, in which said second ohmic resistor (20, 120) comprises a series layout of a plurality of discrete resistors (18, 118), said switches being connected to the series layout at various locations between discrete resistors (18, 118)

7. The device as claimed in one of claims 1 to 3, in which a unidirectional position detector (16, 116) comprises a sensor in the form of a voltage divider, said voltage divider comprising a second ohmic resistor (20, 120) extending substantially along the row of keys of the keyboard, conducting lines extending from the second ohmic resistor (20, 120) and arranged at a certain distance from one another, a comb-like conductor, whose teeth are arranged in an interdigital manner between said conducting lines, and an activation layer made of semiconducting material, in which the comb-like conductor is connected to the output connection (22, 122) of the position detector (16, 116) and the second ohmic resistor (20, 120) is connected between the two input connections of the position detector (16, 116).

8. The device as claimed in one of claims 1 to 3, in which a unidirectional position detector (16, 116) comprises several voltage divider-like sensors laid out in series

9. The device as claimed in one of claims 7 or 8, in which the second ohmic resistor of the voltage divider-like sensor is a nonlinear resistor

10. The device as claimed in one of claims 1 to 9, comprising at least one third ohmic resistor (50, 52, 54) wired between said first ohmic resistor (28) and the respective terminal (32, 34) of the data input device (10) or between said second ohmic resistor (20) and the respective terminal (26) of the data input device (10), said third ohmic resistor (50, 52, 54) being short-circuitable with the aid of a bypass circuit (56, 58, 60) including a switch (62, 64, 66)

11. The device as claimed in one of claims 1 to 10, comprising at least one series layout (72) of a fourth ohmic resistor (74) and of a switch (76), said series layout (72) being wired up in parallel to said first ohmic resistor (28) or to said second ohmic resistor (20)

12. The device as claimed in one of claims 4 to 6, in which at least two discrete switches (112) are disposed at a distance such that alternate or simultaneous actuation of the two discrete switches (112) is possible using a single control element

13. The device as claimed in claim 8, in which at least two voltage divider-like sensors are disposed at a distance such that alternate or simultaneous actuation of the two voltage divider-like sensors is possible using a single control element

14. The device as claimed in claim 7 or 8, in which virtual keys are defined for a voltage divider-like sensor by associating a certain range of resistances with each of the keys, and in which at least two keys are defined in such a way as to be physically disposed at a distance such that alternate or simultaneous actuation of the two keys is possible using a single control element

15. The device as claimed in one of the preceding claims, in which at least two unidirectional position detectors (16, 116) are disposed at a distance such that alternate or simultaneous actuation of the two position detectors (16, 116) is possible using a single control element.

16. The device as claimed in one of claims 4 to 6, in which said discrete switches of several unidirectional position detectors are connected to one and the same second ohmic resistor

## Patentansprüche

1. Dateneingabevorrichtung (10, 110) mit mehreren Tasten (12, 112), wobei die Tasten in mindestens zwei Zeilen (14, 114) angeordnet sind,
**dadurch gekennzeichnet,**
**dass** die Dateneingabevorrichtung (10, 110) eine Vielzahl unidirektionaler Positionsdetektoren (16, 116) aufweist, wobei jeweils ein unidirektionaler Positionsdetektor (16, 116) jeweils einer Tastenzeile (14, 114) zugeordnet ist und jeder unidirektionale Positionsdetektor (16, 116) einen ersten Eingangsanschluss, einen zweiten Eingangsanschluss und einen Ausgangsanschluss (22, 122) aufweist,
**dass** die Ausgangsanschlüsse (22, 122) der unidirektionalen Positionsdetekoren (16, 116) an verschiedenen Stellen mit einem ersten ohmschen Widerstand (28, 128) verbunden sind, und
**dass** die ersten Eingangsanschlüsse mit einer ersten Anschlussklemme (24, 124) der Dateneingabevorrichtung verbunden sind und die zweiten Eingangsanschlüsse mit einer zweiten Anschlussklemme (26, 126) der Dateneingabevorrichtung (10, 110) verbunden sind

2. Vorrichtung nach Anspruch 1, wobei der erste ohmsche Widerstand (28) einen Streifen aus resistivem Material aufweist, wobei die Ausgangsanschlüsse (22, 122) der unidirektionalen Positionsdetektoren (16, 116) an verschiedenen Stellen mit dem Streifen aus resistivem Material verbunden sind

3. Vorrichtung nach Anspruch 1, wobei der erste ohmsche Widerstand (28, 128) eine Reihenschaltung einer Vielzahl diskreter Widerstände (30, 130) aufweist, wobei die Ausgangsanschlüsse (22, 122) der unidirektionalen Positionsdetektoren (16, 116) mit der Reihenschaltung an verschiedenen Stellen zwischen diskreten Widerständen (30, 130) verbunden sind

4. Vorrichtung nach einem der Ansprüche 1 bis 3, wobei ein unidirektionaler Positionsdetektor (16, 116) eine Vielzahl diskreter Schalter aufweist, wobei die Schalter auf einer Seite mit dem Ausgangsanschluss (22, 122) des Positionsdetektors (16, 116) und auf der anderen Seite an verschiedenen Stellen mit einem zweiten ohmschen Widerstand (20, 120) verbunden sind, welcher zweite ohmsche Widerstand (20, 120) zwischen die beiden Eingangsanschlüsse des Positionsdetektors geschaltet ist

5. Vorrichtung nach Anspruch 4, **dadurch gekennzeichnet, dass** der zweite ohmsche Widerstand (20, 120) einen Streifen aus resistivem Material aufweist, wobei die Schalter an verschiedenen Stellen mit dem Streifen aus resistivem Material verbunden sind

6. Vorrichtung nach Anspruch 4, wobei der zweite ohmsche Widerstand (20, 120) eine Reihenschaltung einer Vielzahl diskreter Widerstände (18, 118) aufweist, wobei die Schalter mit der Reihenschaltung an verschiedenen Stellen zwischen diskreten Widerständen (18, 118) verbunden sind

7. Vorrichtung nach einem der Ansprüche 1 bis 3, wobei ein unidirektionaler Positionsdetektor (16, 116) einen als Spannungsteiler ausgebildeten Sensor aufweist, wobei der Spannungsteiler einen sich im Wesentlichen entlang der Tastenzeile der Tastatur erstreckenden zweiten ohmschen Widerstand (20, 120), von dem ohmschen Widerstand (20, 120) ausgehende und in einem gewissen Abstand voneinander angeordnete Leitungen, einen kammförmigen Leiter, dessen Zähne zwischen den Leitungen interdigital angeordnet sind, und eine Aktivierungsschicht aus Halbleitermaterial aufweist, und wobei der kammförmige Leiter mit dem Ausgangsanschluss (22, 122) des Positionsdetektors (16, 116) verbunden ist und der zweite ohmsche Widerstand (20, 120) zwischen die beiden Eingangsanschlüsse des Positionsdetektors (16, 116) geschaltet ist

8. Vorrichtung nach einem der Ansprüche 1 bis 3, wobei ein unidirektionaler Positionsdetektor (16, 118) mehrere als Spannungsteiler ausgebildete, in Reihe geschaltete Sensoren aufweist

9. Vorrichtung nach einem der Ansprüche 7 oder 8, wobei der zweite ohmsche Widerstand des als Spannungsteiler ausgebildeten Sensors ein nichtlinearer Widerstand ist

10. Vorrichtung nach einem der Ansprüche 1 bis 9, mit mindestens einem dritten ohmschen Widerstand (50, 52, 54), welcher zwischen den ersten ohmschen Widerstand (28) und die jeweilige Anschlussklemme (32, 34) der Dateneingabevorrichtung (10) oder zwischen den zweiten ohmschen Widerstand (20) und die jeweilige Anschlussklemme (26) der Dateneingabevorrichtung (10) geschaltet ist, wobei der dritte ohmsche Widerstand (50, 52, 54) mittels einer mit einem Schalter (62, 64, 66) versehenen Abzweigschaltung (56, 58, 60) kurzschließbar ist

11. Vorrichtung nach einem der Ansprüche 1 bis 10, mit mindestens einer Reihenschaltung (72) eines vierten ohmschen Widerstandes (74) und eines Schalters (76), wobei die Reihenschaltung (72) mit dem ersten ohmschen Widerstand (28) oder dem zweiten ohmschen Widerstand (20) parallel geschaltet ist

12. Vorrichtung nach einem der Ansprüche 4 bis 6, wobei mindestens zwei diskrete Schalter (112) in einem solchen Abstand angeordnet sind, dass eine abwechselnde oder gleichzeitige Betätigung der beiden diskreten Schalter (112) über ein einziges Steuerelement möglich ist

13. Vorrichtung nach Anspruch 8, wobei mindestens zwei als Spannungsteiler ausgebildete Sensoren in einem solchen Abstand angeordnet sind, dass eine abwechselnde oder gleichzeitige Betätigung der beiden als Spannungsteiler ausgebildeten Sensoren über ein einziges Steuerelement möglich ist

14. Vorrichtung nach Anspruch 7 oder 8, wobei virtuelle Tasten für einen als Spannungsteiler ausgebildeten Sensor definiert sind und jeder der Tasten ein bestimmter Widerstandsbereich zugeordnet ist, und wobei mindestens zwei Tasten so definiert sind, dass sie physisch in einem solchen Abstand angeordnet sind, dass eine abwechselnde oder gleichzeitige Betätigung der beiden Tasten über ein einziges Steuerelement möglich ist

15. Vorrichtung nach einem der vorhergehenden Ansprüche, wobei mindestens zwei unidirektionale Positionsdetektoren (16, 116) in einem solchen Abstand angeordnet sind, dass eine abwechselnde oder gleichzeitige Betätigung der beiden Positionsdetektoren (16, 116) über ein einziges Steuerelement möglich ist

16. Vorrichtung nach einem der Ansprüche 4 bis 6, wobei die diskreten Schalter mehrerer unidirektionaler Positionsdetektoren mit einem gleichen zweiten ohmschen Widerstand verbunden sind
